(19) Europäisches Patentamt

European Patent Office

Office européen des brevets

(11) **EP 0 918 397 A1**

(12) **DEMANDE DE BREVET EUROPEEN**

(43) Date de publication:
**26.05.1999 Bulletin 1999/21**

(51) Int Cl.$^6$: **H03M 1/08**

(21) Numéro de dépôt: **98203823.4**

(22) Date de dépôt: **12.11.1998**

| | |
|---|---|
| (84) Etats contractants désignés:<br>**AT BE CH CY DE DK ES FI FR GB GR IE IT LI LU MC NL PT SE**<br>Etats d'extension désignés:<br>**AL LT LV MK RO SI** | (72) Inventeur: **Morisson, Richard**<br>**75008 Paris (FR)** |
| (30) Priorité: **21.11.1997 FR 9714668** | (74) Mandataire: **Caron, Jean et al**<br>**Société Civile S.P.I.D.**<br>**156, Boulevard Haussmann**<br>**75008 Paris (FR)** |
| (71) Demandeur: **Koninklijke Philips Electronics N.V.**<br>**5621 BA Eindhoven (NL)** | |

(54) **Dispositif de conversion analogique/numérique à signaux de sortie synchrones**

(57)    La présente invention concerne un dispositif de conversion analogique/numérique, destiné à convertir une tension d'entrée analogique Vin en un signal de sortie numérique codé sur N bits OUT(O:N-1), comprenant :

.    un premier décodeur FNE, destiné à générer les bits de poids faible OUT(O:K) du signal de sortie,
.    un deuxième décodeur CRS, destiné à générer des signaux représentatifs de transitions que doivent subir les bits de poids fort OUT(i+1) du signal de sortie, pour i=K à N-2.

Selon l'invention, chaque transition du bit OUT(i+1) est signalée par des signaux dits antérieur et postérieur A(i+1) et P(i+1), un encodeur ENC étant muni de moyens pour synchroniser ladite transition avec une transition du bit de poids immédiatement inférieur OUT(i).

Applications : Conversion analogique/numérique de signaux vidéo.

FIG. 2

## Description

La présente invention concerne un dispositif de conversion analogique/numérique, destiné à convertir une tension d'entrée analogique en un signal de sortie numérique codé sur N bits OUT(O:N-1), dont chaque bit OUT(i) pour i=0 à N-1, doit prendre successivement des états actif et inactif lorsque la valeur de la tension d'entrée dépasse respectivement (2m+1) et (2m+2) fois une valeur prédéterminée Vi qui est associée audit bit OUT(i), m pouvant varier de 0 à $2^{(N-1-i)}$-1, dispositif comprenant :

- une échelle de résistances disposées en série entre deux bornes d'alimentation, destinée à générer une série de tensions de référence,
- une série de comparateurs dont chacun est destiné à effectuer une comparaison entre la tension d'entrée et une tension de référence,
- un premier décodeur, destiné à générer, sur la base des résultats desdites comparaisons, les K+1 bits de poids faible OUT(O:K) du signal de sortie,
- un deuxième décodeur, destiné à générer, sur la base des résultats desdites comparaisons, des signaux représentatifs de transitions que doivent subir les N-K-1 bits de poids fort OUT(i+1) du signal de sortie, pour i=K à N-2, et
- un encodeur destiné à élaborer chacun desdits bits de poids fort OUT(i+1) du signal de sortie, sur la base notamment des signaux générés par les premier et deuxième décodeurs.

Un tel dispositif de conversion analogique/numérique est connu du brevet américain No. 4,939,517. Dans ce dispositif, le premier décodeur génère de manière précise les bits de poids faible du signal de sortie numérique, tandis que le deuxième décodeur génère des signaux qui constituent des approximations des bits de poids fort du signal de sortie numérique. L'encodeur reçoit ces signaux, ainsi que les bits de poids faible issus du premier décodeur. Il reçoit également, depuis un circuit de contrôle de synchronisation, des signaux dont la vocation est de signaler les plages de variation de la tension d'entrée dans lesquelles les bits de poids fort doivent subir des transitions. Afin d'assurer une synchronisation desdites transitions avec les transitions des bits de poids faible, l'encodeur substitue à chaque signal de sortie du deuxième décodeur une combinaison logique entre ledit signal et au moins un des bits de poids faible, le signal résultant de cette combinaison logique constituant alors un des bits de poids fort du signal de sortie numérique.

La technique de conversion décrite ci-dessus n'est efficace que si le nombre de bits de poids fort est réduit, et est limitée en fréquence. En effet, la largeur de la plage de variation de la tension d'entrée pendant laquelle le bit OUT(K) de poids le plus élevé parmi les bits de poids faible présente un état stable est $2^i$ plus petite que celle pendant laquelle un bit de poids OUT(K+i) de poids K+i présente un état stable. Plus i est grand, plus il est difficile à l'encodeur de synchroniser les transitions des bits de poids fort avec la bonne transition des bits de poids faible, car cette transition devient plus difficile à identifier. Ceci induit une limitation dans la performance dynamique du convertisseur, car les difficultés de synchronisation décrites ci-dessus prennent de l'ampleur à mesure que la fréquence de variation de la tension d'entrée augmente. Des retards intervenant dans la propagation des signaux au sein du dispositif peuvent par exemple conduire à une situation où des transitions des bits de poids faible devant servir de références à la synchronisation se produisent en dehors des intervalles où des transitions nécessaires d'un bit de poids fort sont signalées par le circuit de contrôle de synchronisation. On constate ainsi l'apparition d'une fréquence critique intrinsèque au circuit : lorsque la fréquence de la tension d'entrée dépasse cette fréquence critique, la précision de la conversion analogique/numérique se dégrade très brutalement.

L'invention permet de s'affranchir dans une large mesure de cette limitation en fréquence, en proposant un dispositif de conversion dans lequel les transitions de chacun des bits de poids fort sont synchronisées avec celles de son bit de poids immédiatement inférieur.

En effet, un dispositif de conversion tel que décrit dans le paragraphe introductif est caractérisé selon l'invention en ce que le deuxième décodeur est muni de moyens dits de signalisation pour générer, pour chacun des bits de poids fort OUT(i+1), deux signaux A(i+1) et P(i+1), respectivement appelés antérieur et postérieur, qui présentent des transitions qui encadrent chacune des transitions du bit OUT(i+1), et en ce que l'encodeur est muni de moyens pour synchroniser chaque transition du bit OUT(i+1), signalée par les signaux antérieur et postérieur, avec une transition du bit de poids immédiatement inférieur OUT(i).

Dans ce dispositif de conversion, le bit OUT(i) dont les transitions doivent servir de référence à la synchronisation des transitions du bit OUT(i) présente des états stables tout au long de plages de variation de la tension d'entrée qui sont systématiquement seulement deux fois plus courtes que celles correspondant aux états stables du bit OUT(i+1). Ceci permet en principe d'éviter que les transitions du bit OUT(i) n'interviennent en dehors des plages de variation de la tension d'entrée identifiées par les transitions des signaux antérieur et postérieur A(i+1) et P(i+1) comme étant celles où les transitions du bit OUT(i+1) doivent se produire.

Un mode de réalisation de l'invention est caractérisé en ce que l'encodeur est agencé de sorte qu'une équation logique décrivant l'évolution de chacun des bits de poids fort OUT(i+1), pour i=K à N-2, s'écrive OUT(i+1)=A(i+1).OUTn(i)+P(i+1).OUT(i), où OUTn(i) est un signal complémentaire à OUT(i), les moyens de signalisation du deuxième décodeur étant agencés de sorte que les signaux antérieur et postérieur A(i+1) et P(i+1) prennent respectivement un état actif lorsque la valeur de la tension d'entrée dépasse un premier et un deuxième seuils de tension, récurrents en fonction de l'évolution de la valeur de la tension d'entrée, et respectivement un état inactif lorsque la valeur de la tension d'entrée dépasse un troisième et un quatrième seuils de tension, récurrents en fonction de l'évolution de la valeur de la tension d'entrée.

Dans ce mode de réalisation, les états actifs des signaux antérieurs et postérieurs sont des niveaux logiques "1", qui permettent de synchroniser des transitions d'un bit OUT(i+1) avec des fronts descendants du bit OUT(i).

Un mode de réalisation particulier de l'invention est caractérisé en ce que le $j_{ème}$ seuil de tension récurrent est compris entre (4.p+j).Vi et (4.p+j+1).Vi, j variant de 1 à 4 et p pouvant varier de 0 à $2^{(N-2-i)}$-1.

Selon ce mode de réalisation de l'invention, les signaux antérieur et postérieur A(i+1) et P(i+1) présentent des états stables tout au long de plages de variation de la tension d'entrée qui sont de l'ordre de deux fois plus longues que celles correspondant aux états stables du bit OUT(i). Ceci permet de minimiser encore les risques pour que les transitions du bit OUT(i) servant de référence à la synchronisation d'une transition du bit OUT(i+1) n'interviennent en dehors des plages de variation de la tension d'entrée identifiées par les transitions des signaux antérieur et postérieur A(i+1) et P(i+1) comme étant celles où lesdites transitions doivent se produire.

Dans une variante de ce mode de réalisation, le $j_{ème}$ seuil de tension récurrent est choisi égal à ((4.p+j).Vi)+(Vi/2),j variant de 1 à 4 et p pouvant varier de 0 à $2^{(N-2-i)}$-1.

Ce choix permet d'obtenir une symétrie des transitions des signaux antérieur et postérieur A(i+1) et P(i+1) par rapport aux transitions du bit OUT(i) servant de référence à la synchronisation des transitions du bit OUT(i+1). Cette symétrie confère à l'encodeur la plus grande insensibilité possible au bruit de phase qui pourrait affecter les signaux antérieur et postérieur A(i+1) et P(i+1), où encore le bit OUT(i).

Dans un mode de réalisation particulièrement avantageux de l'invention, un dispositif de conversion tel que décrit ci-dessus est caractérisé en ce qu'il comporte un module de compilation des résultats des comparaisons entre la tension d'entrée et les tensions de référence, destiné à délivrer une série de signaux de sortie S(q.V0), q variant de 1 à $2^N$-1, V0 étant la valeur prédéterminée associée au bit OUT(0), chaque signal S(q.V0) étant destiné à prendre un état actif lorsque la valeur de la tension d'entrée dépasse q.V0, et en ce que les moyens de signalisation du deuxième décodeur sont agencés de sorte que des équations logiques décrivant les évolutions des signaux antérieurs et postérieurs A(i+1) et P(i+1), pour i=K à N-2, s'écrivent :

$$A(i+1) = \sum_{P=o}^{2^{(N-2-i)}-1} S((4.p+3/2).2^i.V0) - S((4.p+7/2).2^i.V0)$$

et

$$P(i+1) = \sum_{P=o}^{2^{(N-2-i)}-1} S((4.p+5/2).2^i.V0) - S((4.p+9/2).2^i.V0)$$

Il sera démontré dans la suite de l'exposé qu'un tel choix des seuils récurrents permet d'élaborer les signaux antérieurs et postérieurs depuis des signaux déjà existants au sein du dispositif de conversion, ce qui évite de recourir à une circuiterie supplémentaire et permet de réaliser ainsi des économies dans les coûts de production du dispositif.

L'invention sera mieux comprise à l'aide de la description suivante de quelques modes de réalisation, faite à titre d'exemple non-limitatif et en regard des dessins annexés, dans lesquels :

- la figure 1 représente une table de vérité décrivant, dans un exemple simple, l'évolution des bits du signal de sortie numérique en fonction de la tension d'entrée analogique,
- la figure 2 est un schéma fonctionnel décrivant un dispositif de conversion analogique/numérique conforme à l'invention,
- la figure 3 est un schéma fonctionnel décrivant un encodeur inclus dans un tel dispositif de conversion,
- la figure 4 est un schéma électrique décrivant une portion d'un tel encodeur,
- la figure 5 est un ensemble de chronogrammes décrivant notamment l'évolution de signaux antérieurs et postérieurs en fonction de la tension d'entrée, et

- la figure 6 est un ensemble de chronogrammes décrivant l'évolution de signaux délivrés par un module de compilation inclus dans un dispositif de conversion conforme à un mode de réalisation particulier de l'invention.

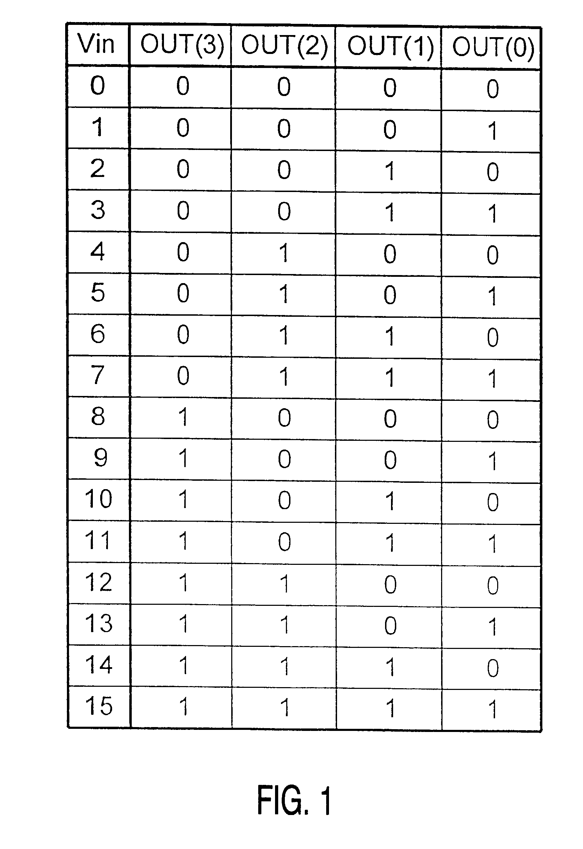

La figure 1 est une table de vérité décrivant, dans un exemple simple où N=4, l'évolution des bits OUT(i) d'un signal de sortie numérique, pour i=0 à N-1, résultant de la conversion analogique/numérique d'une tension d'entrée analogique Vin. On observe que OUT(0) devient actif, c'est-à-dire, dans cet exemple, qu'il prend un état logique "1", lorsque Vin dépasse la valeur 1, puis inactif, c'est-à-dire, dans cet exemple, qu'il prend un état logique "O", lorsque Vin dépasse la valeur 2, puis actif lorsque Vin dépasse la valeur 3, et ainsi de suite jusqu'à ce que Vin dépasse la valeur 15. OUT(1) devient actif lorsque Vin dépasse la valeur 2, puis inactif lorsque Vin dépasse la valeur 4, puis actif lorsque Vin dépasse la valeur 6, et ainsi de suite jusqu'à ce que Vin dépasse la valeur 14. OUT(2) devient actif lorsque Vin dépasse la valeur 4, puis inactif lorsque Vin dépasse la valeur 8, puis actif lorsque Vin dépasse la valeur 12. Enfin, OUT(3) devient actif lorsque Vin dépasse la valeur 8. On peut donc associer à chacun des bits OUT(i) une valeur prédéterminée Vi : au bit OUT(0) est associée la valeur prédéterminée $V0=1$, au bit OUT(1) est associée la valeur prédéterminée $V1=2$, au bit OUT(2) est associée la valeur prédéterminée $V2=4$, et au bit OUT(3) est associée la valeur prédéterminée $V3=8$. Selon ces notations, un raisonnement par récurrence démontre que chaque bit OUT(i) pour i=0 à N-1, doit prendre successivement des états actif et inactif lorsque la valeur de la tension d'entrée dépasse respectivement $(2m+1)$ et $(2m+2)$ fois la valeur prédéterminée Vi qui est associée audit bit OUT(i), m pouvant varier de 0 à $2^{(N-1-i)}-1$. On note également que la valeur prédéterminée Vi associée au bit OUT(i) est égale à $2^i$ fois la valeur prédéterminée V0 associée au bit OUT(0) : $Vi=2^i.V0$.

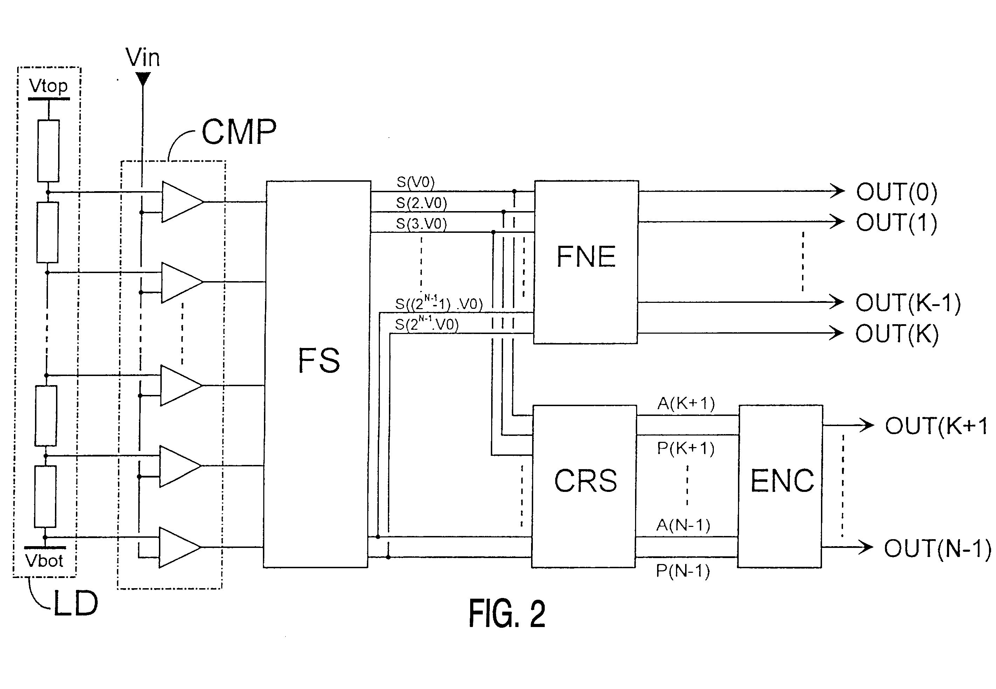

La figure 2 représente schématiquement un dispositif de conversion analogique/numérique conforme à un mode de réalisation de l'invention. Ce dispositif, destiné à convertir une tension d'entrée analogique Vin en un signal de sortie numérique codé sur N bits OUT(O:N-1), comprend :

. une échelle LD de résistances disposées en série entre deux bornes d'alimentation Vtop et Vbot, destinée à générer une série de tensions de référence,
. une série CMP de comparateurs dont chacun est destiné à effectuer une comparaison entre la tension d'entrée Vin et une tension de référence,
. un premier décodeur FNE, destiné à générer, sur la base des résultats desdites comparaisons, les K+1 bits de poids faible OUT(O:K) du signal de sortie,
. un deuxième décodeur CRS, destiné à générer, sur la base des résultats desdites comparaisons, des signaux représentatifs de transitions que doivent subir les N-K-1 bits de poids fort OUT(i+1) du signal de sortie, pour i=K à N-2, et
. un encodeur ENC destiné à élaborer chacun desdits bits de poids fort OUT(i+1) du signal de sortie, sur la base notamment des signaux générés par les premier et deuxième décodeurs FNE et CRS.

Le dispositif de conversion comporte, dans ce mode de réalisation particulier, un module de compilation FS des résultats des comparaisons entre la tension d'entrée Vin et les tensions de référence. Ce module de compilation FS est destiné à délivrer une série de signaux de sortie S(q.V0), q variant de 1 à $2^N-1$, V0 étant la valeur prédéterminée associée au bit OUT(0). Cette valeur V0 représente la variation minimale de la tension d'entrée analogique Vin ayant une influence sur le signal de sortie numérique. Elle détermine donc la résolution, c'est-à-dire la précision maximale, de la conversion analogique/numérique que permet d'atteindre le dispositif. Chaque signal S(q.V0) est destiné à prendre un état actif lorsque la valeur de la tension d'entrée dépasse q.V0. Ces signaux peuvent être indifféremment générés en utilisant une structure dite "complètement parallèle" ou une structure dite "à repliement", suivie ou non d'une interpolation. Ces structures, bien connues du spécialiste, sont notamment décrites dans l'article "An 8-bit Video ADC Incorporating Folding and Interpolation Techniques" de MM. Rob E. Van de Grift, Ivo W.J.M. Rutten et Martien Van der Veen, paru dans le IEEE Journal of Solid-State Circuits, vol. sc-22 n°6 de Décembre 1987.

Le deuxième décodeur CRS est muni de moyens dits de signalisation pour générer, pour chacun des bits de poids fort OUT(i+1), pour i=K à N-2, deux signaux A(i+1) et P(i+1), respectivement appelés antérieur et postérieur, qui présentent des transitions qui encadrent chacune des transitions du bit OUT(i+1). L'encodeur est muni de moyens pour synchroniser chaque transition du bit OUT(i+1), signalée par les signaux antérieur et postérieur, avec une transition du bit de poids immédiatement inférieur OUT(i).

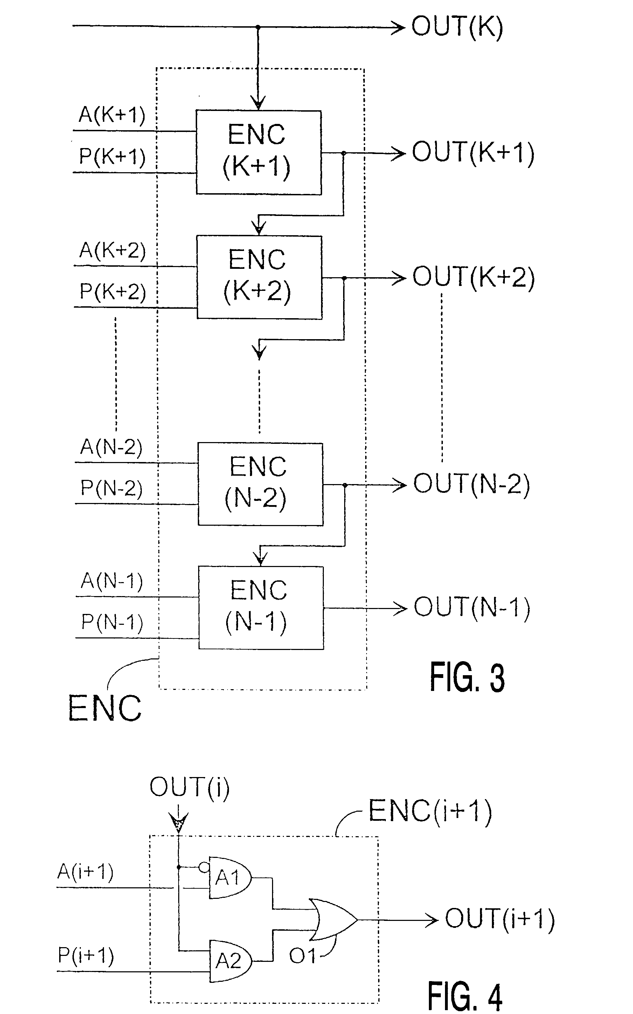

La figure 3 décrit schématiquement la structure de l'encodeur ENC. Cet encodeur est constitué de N-K-1 cellules élémentaires identiques DEC(i+1), pour i=K à N-2, chacune destinée à générer un bit de poids fort OUT(i+1) sur la base de signaux antérieur et postérieur A(i+1) et P(i+1) délivrés par le deuxième décodeur CRS, et du bit de poids immédiatement inférieur OUT(i).

La figure 4 est un schéma électrique représentant un mode de réalisation d'une cellule élémentaire ENC(i+1) incluse dans l'encodeur ENC. Cette cellule est destinée à recevoir en entrée les signaux antérieur et postérieur A(i+1) et P(i+1), ainsi que le bit OUT(i), et à délivrer en sortie le bit OUT(i+1) du signal de sortie numérique du dispositif de conversion. Une porte ET logique A1 à deux entrées reçoit sur une entrée inverseuse le bit OUT(i), et sur son autre entrée le signal antérieur A(i+1). Une porte ET logique A2 à deux entrées reçoit sur une entrée le bit OUT(i), et sur son autre entrée le signal postérieur P(i+1). Les sorties des portes ET logique A1 et A2 sont reliées à deux entrées d'une porte OU logique O1, dont la sortie délivre le bit OUT(i+1), qui a alors pour équation OUT(i+1)=A(i+1).OUTn(i) +P(i+1).OUT(i), où OUTn(i) est un signal complémentaire à OUT(i). Dans ce mode de réalisation, le choix de niveaux logiques "1" pour les états actifs des signaux antérieurs et postérieurs permet de synchroniser des transitions d'un bit OUT(i+1) avec des fronts descendants du bit OUT(i), conformément à l'évolution illustrée par la table de vérité de la figure 1.

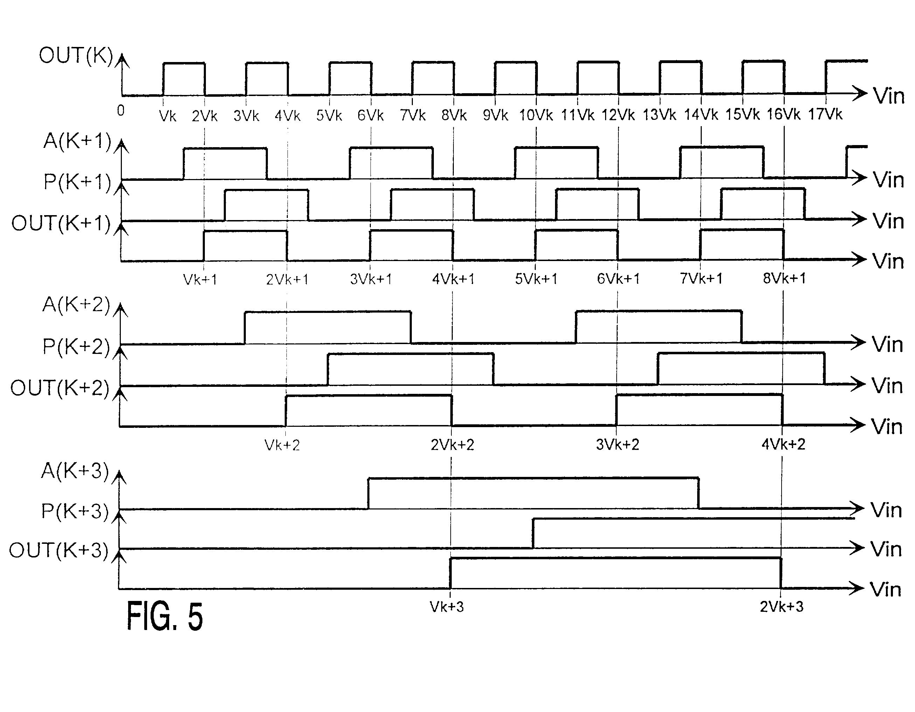

La figure 5 représente un ensemble de chronogrammes qui a pour but de permettre la visualisation du fonctionnement du dispositif de conversion. Les moyens de signalisation du deuxième décodeur CRS sont agencés de sorte que les signaux antérieur et postérieur A(i+1) et P(i+1) prennent respectivement un état actif lorsque la valeur de la tension d'entrée Vin dépasse un premier et un deuxième seuils de tension, récurrents en fonction de l'évolution de la valeur de la tension d'entrée, et respectivement un état inactif lorsque la valeur de la tension d'entrée dépasse un troisième et un quatrième seuils de tension, récurrents en fonction de l'évolution de la valeur de la tension d'entrée. Chaque bit de poids fort OUT(i+1) obéissant à l'équation OUT(i+1)=A(i+1).OUTn(i)+P(i+1).OUT(i), où OUTn(i) est un signal complémentaire à OUT(i), ainsi qu'exposé plus haut, le bit OUT(K+1) prend un état actif lorsque le signal antérieur A(K+1) est à l'état actif et lorsque OUT(i) présente un front descendant. OUT(K+1) conserve cet état actif lorsque OUT(K) redevient actif, car le signal postérieur P(K+1) est alors à l'état actif. OUT(K+1) ne devient inactif que lors du front descendant suivant de OUT(K). Les transitions du bit OUT(K+1), encadrées par celles des signaux antérieur et postérieur A(K+1) et P(K+1), sont ainsi synchronisées avec les fronts descendants du bit de poids immédiatement inférieur OUT(K). On peut transposer la description de ce fonctionnement à l'élaboration des bits OUT(K+2) et OUT (K+3), également représentés sur la figure 5. Ainsi, pour tout i=K à K-N-2, le bit OUT(i) dont les transitions doivent servir de référence à la synchronisation des transitions du bit OUT(i+1) présente des états stables tout au long de plages de variation de la tension d'entrée Vin qui sont systématiquement seulement deux fois plus courtes que celles correspondant aux états stables du bit OUT(i+1). Ceci permet en principe d'éviter que les transitions du bit OUT(i) n'interviennent en dehors des plages de variation de la tension d'entrée identifiées par les transitions des signaux antérieur et postérieur A(i+1) et P(i+1) comme étant celles où les transitions du bit OUT(i+1) doivent se produire.

Dans le cas particulier décrit ici, le $j_{ème}$ seuil de tension récurrent est égal à ((4.p+j).Vi)+(Vi/2), j variant de 1 à 4 et p pouvant varier de 0 à $2^{(N-2-i)}-1$. Ainsi, le signal antérieur A(k+1) présente des fronts montants lorsque la tension d'entrée Vin dépasse 3/2.Vk, 11/2.Vk, 19/2.Vk, 27/2.Vk, 35/2.Vk,..., et des fronts descendants lorsque la tension d'entrée Vin dépasse 7/2.Vk, 15/2.Vk, 23/2.Vk, 31/2.Vk, ... Le signal postérieur P(k+1) présente des fronts montants lorsque la tension d'entrée Vin dépasse 5/2.Vk, 13/2.Vk, 21/2.Vk, 29/2.Vk,..., et des fronts descendants lorsque la tension d'entrée Vin dépasse 9/2.Vk, 17/2.Vk, 25/2.Vk, 33/2.Vk,... Un tel choix des seuils de tensions récurrents présente plusieurs avantages : tout d'abord, les signaux antérieur et postérieur A(i+1) et P(i+1) présentent des états stables tout au long de plages de variation de la tension d'entrée qui sont deux fois plus longues que celles correspondant aux états stables du bit OUT(i). Ceci permet de minimiser encore les risques pour que les transitions du bit OUT(i) servant de référence à la synchronisation d'une transition du bit OUT(i+1) n'interviennent en dehors des plages de variation de la tension d'entrée identifiées par les transitions des signaux antérieur et postérieur A(i+1) et P(i+1) comme étant celles où lesdites transitions doivent se produire. De plus, ce choix permet d'obtenir une symétrie des transitions des signaux antérieur et postérieur A(i+1) et P(i+1) par rapport aux transitions du bit OUT(i) servant de référence à la synchronisation des transitions du bit OUT(i+1). Cette symétrie confère à l'encodeur la plus grande insensibilité possible au bruit de phase qui pourrait affecter les signaux antérieur et postérieur A(i+1) et P(i+1), où encore le bit OUT (i). Elle autorise en effet un décalage des fronts descendants du bit OUT(i) d'aussi grande ampleur vers les transitions du signal antérieur A(i+1) que vers les transitions du signal postérieur P(i+1). Une dissymétrie des transitions des signaux antérieur et postérieur A(i+1) et P(i+1) par rapport aux transitions du bit OUT(i) impliquerait une plus grande tolérance au bruit de phase dans un sens, mais une plus faible tolérance dans l'autre sens. Enfin la symétrie des transitions des signaux antérieur et postérieur A(i+1) et P(i+1) par rapport aux transitions du bit OUT(i) permet la mise en oeuvre d'un mode de réalisation particulièrement avantageux des signaux antérieurs et postérieurs, dont la compréhension sera facilitée par la figure suivante.

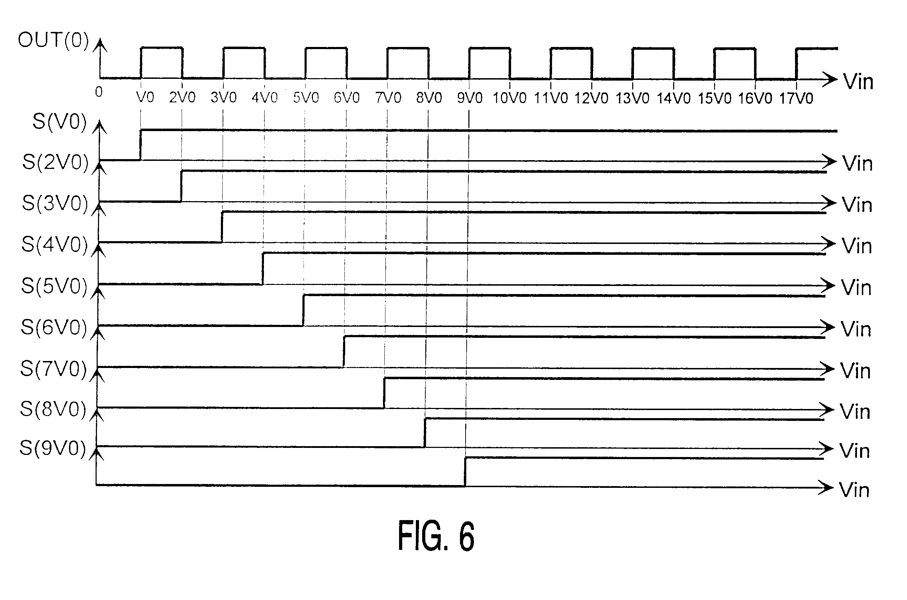

La figure 6 est un ensemble de chronogrammes décrivant l'évolution de signaux de sortie S(q.V0) du module de compilation FS pour q=1 à 9. Chacun de ces signaux présente un front montant lorsque la tension d'entrée Vin atteint la valeur p.V0, et reste à l'état actif lorsque Vin augmente au-delà de ce seuil. La symétrie des transitions des signaux antérieur et postérieur A(i+1) et P(i+1) par rapport aux transitions du bit OUT(i) servant de référence à la synchronisation des transitions du bit OUT(i+1) obtenue en choisissant des seuils de tensions récurrents à mi-chemin entre deux multiples successifs de la valeur prédéterminée Vi associée au bit OUT(i) autorise l'utilisation des signaux S(q.V0) pour l'élaboration des signaux antérieurs et postérieurs. En effet, il a déjà été observé que chaque valeur prédéterminée Vi associée à un bit OUT(i) du signal de sortie numérique du dispositif est égale à $2^i$.V0. Chaque seuil de tension récurrent correspond donc à l'un des seuils q.V0. Un exemple simple permet de visualiser cette propriété :

si, dans les chronogrammes de la figure 5, on pose K=1, les premier, deuxième, troisième et quatrième seuils de tension récurrents des signaux antérieur et postérieur A(2) et P(2) sont respectivement 3/2.V1, 5/2.V1, 7/2.V1, 9/2.V1,... soit encore 3.V0, 5.V0, 7.V0, 9.V0... Les premier, deuxième, troisième et quatrième seuils de tension récurrents des signaux antérieur et postérieur A(3) et P(3) sont respectivement 3/2.V2, 5/2.V2, 7/2.V2, 9/2.V2,...soit encore 6.V0, 10.V0, 14.V0, 18.V0... Les équations des signaux antérieurs et postérieurs A(i+1) et P(i+1) résultant de la disposition symétrique des seuils de tension récurrents par rapport à deux multiples successifs de Vi s'écrivent, pour i=K à N-2 :

$$A(i+1) = \sum_{P=0}^{2^{(N-2-i)}-1} S((4.p+3/2).Vi) - S((4.p+7/2).Vi)$$

et

$$P(i+1) = \sum_{P=0}^{2^{(N-2-i)}-1} S((4.p+5/2).Vi) - S((4.p+9/2).Vi)$$

Dans le mode de réalisation particulier décrit dans cet exemple, les signaux antérieurs et postérieurs A(i+1) et P(i+1) sont générés sur la base des signaux de sortie du module de compilation FS selon les équations :

$$A(i+1) = \sum_{P=0}^{2^{(N-2-i)}-1} S((4.p+3/2).2^i.V0) - S((4.p+7/2).2^i.V0)$$

et

$$P(i+1) = \sum_{P=0}^{2^{(N-2-i)}-1} S((4.p+5/2).2^i.V0) - S((4.p+9/2).2^i.V0)$$

D'autres structures, connues de l'homme du métier et ne sortant pas du cadre de l'invention, peuvent bien sûr être mises en oeuvre pour générer les signaux antérieurs et postérieurs. Néanmoins, celle qui a été décrite ci-dessus présente l'avantage d'utiliser des signaux déjà existants au sein du dispositif de conversion, ce qui évite de recourir à une circuiterie supplémentaire et permet de réaliser ainsi des économies dans les coûts de production du dispositif.

**Revendications**

1.  Dispositif de conversion analogique/numérique, destiné à convertir une tension d'entrée analogique en un signal de sortie numérique codé sur N bits OUT(O:N-1), dont chaque bit OUT(i) pour i=O à N-1, doit prendre successivement des états actif et inactif lorsque la valeur de la tension d'entrée dépasse respectivement (2m+1) et (2m+2) fois une valeur prédéterminée Vi qui est associée audit bit OUT(i), m pouvant varier de 0 à $2^{(N-1-i)}-1$, dispositif comprenant :

    .    une échelle de résistances disposées en série entre deux bornes d'alimentation, destinée à générer une série de tensions de référence,
    .    une série de comparateurs dont chacun est destiné à effectuer une comparaison entre la tension d'entrée et une tension de référence,
    .    un premier décodeur, destiné à générer, sur la base des résultats desdites comparaisons, les K+1 bits de poids faible OUT(O:K) du signal de sortie,
    .    un deuxième décodeur, destiné à générer, sur la base des résultats desdites comparaisons, des signaux représentatifs de transitions que doivent subir les N-K-1 bits de poids fort OUT(i+1) du signal de sortie, pour i=K à N-2, et

. un encodeur destiné à élaborer chacun desdits bits de poids fort OUT(i+1) du signal de sortie, sur la base notamment des signaux générés par les premier et deuxième décodeurs,

dispositif caractérisé en ce que le deuxième décodeur est muni de moyens dits de signalisation pour générer, pour chacun des bits de poids fort OUT(i+1), deux signaux A(i+1) et P(i+1), respectivement appelés antérieur et postérieur, qui présentent des transitions qui encadrent chacune des transitions du bit OUT(i+1), et en ce que l'encodeur est muni de moyens pour synchroniser chaque transition du bit OUT(i+1), signalée par les signaux antérieur et postérieur, avec une transition du bit de poids immédiatement inférieur OUT(i).

2. Dispositif de conversion analogique/numérique selon la revendication 1, caractérisé en ce que l'encodeur est agencé de sorte qu'une équation logique décrivant l'évolution de chacun des bits de poids fort OUT(i+1), pour i=K à N-2, s'écrive OUT(i+1)=A(i+1).OUTn(i)+P(i+1).OUT(i), où OUTn(i) est un signal complémentaire à OUT(i), les moyens de signalisation du deuxième décodeur étant agencés de sorte que les signaux antérieur et postérieur A (i+1) et P(i+1) prennent respectivement un état actif lorsque la valeur de la tension d'entrée dépasse un premier et un deuxième seuils de tension, récurrents en fonction de l'évolution de la valeur de la tension d'entrée, et respectivement un état inactif lorsque la valeur de la tension d'entrée dépasse un troisième et un quatrième seuils de tension, récurrents en fonction de l'évolution de la valeur de la tension d'entrée.

3. Dispositif de conversion analogique/numérique selon la revendication 2, caractérisé en ce que le $j_{\text{ème}}$ seuil de tension récurrent est compris entre $(4.p+j).Vi$ et $(4.p+j+1).Vi$, j variant de 1 à 4 et p pouvant varier de 0 à $2^{(N-2-i)}-1$.

4. Dispositif de conversion analogique/numérique selon la revendication 3, caractérisé en ce que le $j_{\text{ème}}$ seuil de tension récurrent est égal à $((4.p+j).Vi)+(Vi/2)$, j variant de 1 à 4 et p pouvant varier de 0 à $2^{(N-2-i)}-1$.

5. Dispositif de conversion analogique/numérique selon la revendication 4, caractérisé en ce qu'il comporte un module de compilation des résultats des comparaisons entre la tension d'entrée et les tensions de référence, destiné à délivrer une série de signaux de sortie S(q.V0), q variant de 1 à $2^N$-1, VO étant la valeur prédéterminée associée au bit OUT(0), chaque signal S(q.V0) étant destiné à prendre un état actif lorsque la valeur de la tension d'entrée dépasse q.V0, et en ce que les moyens de signalisation du deuxième décodeur sont agencés de sorte que des équations logiques décrivant les évolutions des signaux antérieurs et postérieurs A(i+1) et P(i+1), pour i=K à N-2, s'écrivent :

$$A(i+1) = \sum_{P=o}^{2^{(N-2-i)}-1} S((4.p+3/2).2^i.V0) - S((4.p+7/2).2^i.V0)$$

et

$$P(i+1) = \sum_{P=o}^{2^{(N-2-i)}-1} S((4.p+5/2).2^i.V0) - S((4.p+9/2).2^i.V0)$$

| Vin | OUT(3) | OUT(2) | OUT(1) | OUT(0) |
|-----|--------|--------|--------|--------|
| 0   | 0      | 0      | 0      | 0      |
| 1   | 0      | 0      | 0      | 1      |
| 2   | 0      | 0      | 1      | 0      |
| 3   | 0      | 0      | 1      | 1      |
| 4   | 0      | 1      | 0      | 0      |
| 5   | 0      | 1      | 0      | 1      |
| 6   | 0      | 1      | 1      | 0      |
| 7   | 0      | 1      | 1      | 1      |
| 8   | 1      | 0      | 0      | 0      |
| 9   | 1      | 0      | 0      | 1      |
| 10  | 1      | 0      | 1      | 0      |
| 11  | 1      | 0      | 1      | 1      |
| 12  | 1      | 1      | 0      | 0      |
| 13  | 1      | 1      | 0      | 1      |
| 14  | 1      | 1      | 1      | 0      |
| 15  | 1      | 1      | 1      | 1      |

# FIG. 1

FIG. 2

Vin

CMP

LD

Vtop

Vbot

FS

FNE

CRS

ENC

OUT(0)
OUT(1)
OUT(K-1)
OUT(K)
OUT(K+1)
OUT(N-1)

S(V0)
S(2.V0)
S(3.V0)
S((2$^{N-1}$-1) . V0)
S(2$^{N-1}$.V0)

A(K+1)
P(K+1)
A(N-1)
P(N-1)

OUT(K)

A(K+1)
P(K+1)
ENC
(K+1)
OUT(K+1)

A(K+2)
P(K+2)
ENC
(K+2)
OUT(K+2)

A(N-2)
P(N-2)
ENC
(N-2)
OUT(N-2)

A(N-1)
P(N-1)
ENC
(N-1)
OUT(N-1)

ENC

**FIG. 3**

OUT(i)

ENC(i+1)

A(i+1) ──── A1

P(i+1) ──── A2    O1 ──→ OUT(i+1)

**FIG. 4**

FIG. 5

EP 0 918 397 A1

FIG. 6

EP 0 918 397 A1

Office européen
des brevets

**RAPPORT DE RECHERCHE EUROPEENNE**

Numéro de la demande

EP 98 20 3823

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int.Cl.6) |
|---|---|---|---|
| A | MORISSON R: "A 10-BIT ADV (3 V, 50MW, 20 MSAMPLES/S) FOR CAMCORDER APPLICATIONS" INTERNATIONAL CONFERENCE ON CONSUMER ELECTRONICS - DIGEST OF TECHNI PAPERS, ROSEMONT, JUNE 7 - 9 1995, no. CONF. 14, 7 juin 1995, page 214/215 XP000547792 INSTITUTE OF ELECTRICAL AND ELECTRONICS ENGINEERS * page 214, colonne de droite, alinéa 2; figure 1 * | 1-5 | H03M1/08 |
| A,D | EP 0 328 213 A (PHILIPS NV) 16 août 1989 * figures 4,9 * | 1 | |

| DOMAINES TECHNIQUES RECHERCHES (Int.Cl.6) |
|---|
| H03M |

Le présent rapport a été établi pour toutes les revendications

| Lieu de la recherche | Date d'achèvement de la recherche | Examinateur |
|---|---|---|
| LA HAYE | 29 janvier 1999 | Verhoof, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

ANNEXE AU RAPPORT DE RECHERCHE EUROPEENNE
RELATIF A LA DEMANDE DE BREVET EUROPEEN NO.

EP 98 20 3823

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-01-1999

| Document brevet cité au rapport de recherche | Date de publication | Membre(s) de la famille de brevet(s) | Date de publication |
|---|---|---|---|
| EP 0328213 A | 16-08-1989 | US 4939517 A | 03-07-1990 |
| | | DE 68924609 D | 30-11-1995 |
| | | DE 68924609 T | 30-05-1996 |
| | | HK 144596 A | 09-08-1996 |
| | | JP 1245717 A | 29-09-1989 |
| | | JP 2816354 B | 27-10-1998 |
| | | KR 9707352 B | 07-05-1997 |

EPO FORM P0460